(19) Europäisches Patentamt
European Patent Office
Office européen des brevets

(11) Publication number: 0 410 794 A2

# (12) EUROPEAN PATENT APPLICATION

(21) Application number: 90308280.8

(22) Date of filing: 27.07.90

(51) Int. Cl.[5]: G03F 7/038, G03F 7/075

(30) Priority: 28.07.89 US 386490

(43) Date of publication of application:
30.01.91 Bulletin 91/05

(84) Designated Contracting States:
DE FR GB IT NL

(71) Applicant: HOECHST CELANESE CORPORATION
Route 202-206 North
Somerville, New Jersey(US)

(72) Inventor: Jain, Sangya
891 Ardsley Road
Bridgewater, New Jersey(US)
Inventor: Khanna, Dinesh N.
39 Musket Road
West Warwick, Rhode Island(US)
Inventor: Potvin, Robert E.
25 Woodbine Road
West Warwick, Rhode Island(US)

(74) Representative: De Minvielle-Devaux, Ian Benedict Peter et al
CARPMAELS & RANSFORD 43, Bloomsbury Squareare
London WC1A 2RA(GB)

## (54) Maleimide containing, negative working deep UV photoresist.

(57) A method for producing a negative image by coating a substrate with a photosensitive layer containing a self-crosslinkable maleimide copolymer capable of crosslinking in the presence of a photogenerated acid and heat. The composition is coated and dried on a substrate, then imagewise exposed, baked and developed with an aqueous alkaline solution.

EP 0 410 794 A2

## BACKGROUND OF THE INVENTION

The present invention relates to compositions suitable for use as photoresists. More particularly, the invention provides compositions suitable for deep uv lithography which are negative working and developable in aqueous alkaline solutions. The invention provides a method for producing a negative image employing compositions containing a resin which is an imide copolymer which together with a sensitizing agent is capable of crosslinking upon exposure and heat treating.

It is well known in the art to produce positive photoresist formulations such as those described in United States Patents 3,666,473; 4,115,128 and 4,173,470. These include alkali soluble phenol formaldehyde novolak resins together with light sensitive materials, usually a substituted naphthoquinone diazide compound. The resins and sensitizers are dissolved in an organic solvent and are applied as a thin film or coating to a substrate suitable for the particular application desired. The resin component of these photoresist formulations is soluble in aqueous alkaline solutions, but the sensitizer is not. Upon imagewise exposure of the coated substrate to actinic radiation, the exposed areas of the coating are rendered more soluble than the unexposed areas. This difference in solubility rates causes the exposed areas of the photoresist coating to be dissolved when the substrate is immersed in an alkaline developing solution while the unexposed areas are largely unaffected, thus producing a positive relief pattern on the substrate. The uncovered substrate is thereafter subjected to an etching process. The photoresist coating protects the coated areas of the substrate from the etchant and thus the etchant is only able to etch the uncovered areas of the substrate. Thus, an etched pattern can be created on the substrate which corresponds to the pattern of the mask, stencil, template, etc., that was used to create selective exposure patterns on the coated substrate prior to development. The relief pattern of photoresist on a substrate produced by this method is useful for various applications including the manufacture of miniaturized integrated circuits.

The ability to reproduce very small dimensions, is extremely important in the production of large scale integrated circuits on silicon chips and similar components. Circuit density on such a chip can only be increased, assuming photolithography techniques are utilized, by increasing the resolution capabilities of the resist. Although negative photoresists, wherein the exposed areas of resist coating become insoluble and the unexposed areas are dissolved away by the developer, have been extensively used for this purpose by the semiconductor industry, positive photoresists have inherently higher resolution and have been used as replacements for the negative resists.

In this regard, photoresists have been categorized as being either positive working or negative working. In a negative working resist composition, the imagewise light struck areas harden and form the image areas of the resist after removal of the unexposed areas with a developer. In a positive working resist the exposed areas are the non-image areas. The light struck parts are rendered soluble in aqueous alkali developers.

It has been observed that prior negative acting photoresist films have a tendency to swell during the development because organic solvents are employed as developers. Consequently, it is difficult to form patterns having a narrow open gap between two pads of resist because the resist remaining behind swells such that the narrow gap is bridged over, and the pads touch each other during development. Even though the resist film will shrink after being removed from the developer, in the locations where swollen resist contacted another part of the pattern a film bridge will be created between the two parts of the pattern. Due to these swelling problems and because positive acting resists are known not to swell upon development, it has become accepted practice to utilize positive acting resists for high resolution microlithography.

This invention circumvents this problem by using binder resins which are aqueous alkaline soluble which eliminates the need to use organic solvent containing developers which are environmentally disadvantageous, expensive, and cause resin swelling, which bridges the fine image lines. In addition, the resins of the present invention do not highly absorb in the deep uv portion of the spectrum and therefore short wavelength exposures are possible, allowing finer geometries. Conventionally, resins used in positive photoresists are novolaks and polyvinyl phenols which are highly absorbing in the deep uv region and do not allow sufficient light to penetrate the film. In addition, the prior negative working, image reversal photoresists require the use of a separate thermal crosslinking agent in the composition admixture. The present composition employs a resin which is self-crosslinking and does not require an additional crosslinker. The sensitizer component generates an acid upon exposure to ultraviolet radiation. This acid crosslinks the resin in the exposed areas upon heating. The unexposed areas remain alkaline soluble and are removed by the developer whereas the crosslinked exposed areas remain.

## Summary of the Invention

The invention provides an aqueous alkaline soluble, crosslinkable resin having the formula:

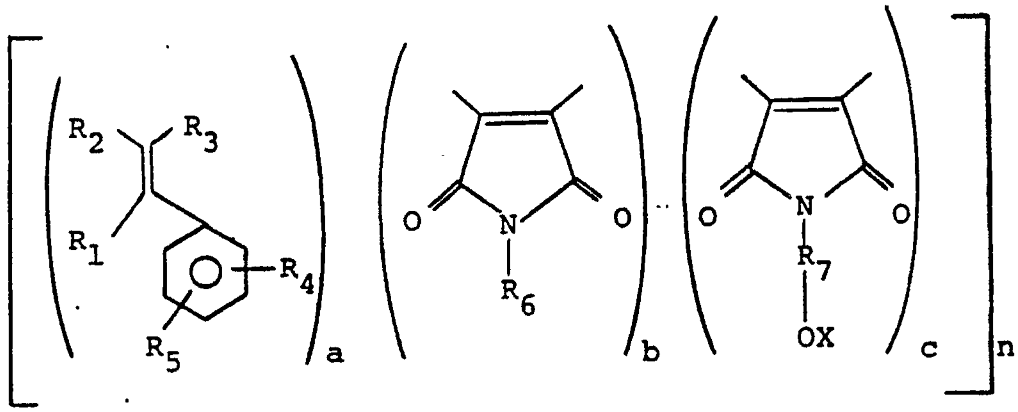

wherein $R_1$, $R_2$, and $R_3$ are independently $C_1$-$C_5$ alkyl or hydrogen;
$R_4$ is $C_1$-$C_5$ alkyl, halogen, hydrogen or $C_1$-$C_5$ alkyl substituted with halogen
$R_5$ is H, $C_1$ to $C_5$ alkyl, $OCO(C_1$-$C_5$ alkyl), OH, halogen, ($C_1$-$C_5$) alkoxy or aryl
$R_6$ is ($C_1$-$C_5$ alkyl)OH, $C_1$-$C_5$ alkyl or hydrogen
$R_7$ is $C_1$-$C_5$ alkyl
X is H or

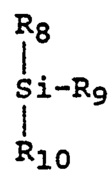

$R_8$, $R_9$ and $R_{10}$ are independently $C_1$-$C_5$ alkyl or phenyl
a = 1-3
b = 0-3
c = 1-3
n is a number to provide the resin a molecular weight in the range of from about 1,000 to about 800,000.

The invention also provides a photosensitive composition which comprises the above resin in admixture with a photosensitizer which is capable of generating a sufficient amount of an acid upon exposure to actinic radiation to cause the crosslinking of the resin upon subsequent heating at a sufficient temperature for a sufficient time. The invention still further provides a photosensitive element which comprises the foregoing admixture coated and dried on a substrate. The invention also provides a method for producing a negative image which comprises imagewise exposing the aforesaid element to sufficient actinic (including ultraviolet and x-ray), electron beam or ion beam radiation to cause an imagewise differential, subsequent heating at a sufficient temperature and for a sufficient time to cause the crosslinking of the resin, and removing the non-exposed areas with a developer which is preferably an aqueous alkaline developer in the absence of organic solvents.

## Detailed Description of the Preferred Embodiment

The copolymers useful within the context of this invention may be prepared by copolymerizing the individual monomers by methods which are per se well known to the skilled artisan. The polymers of the present invention must contain a proportion of acid crosslinkable groups large enough to create a significant solubility difference between irradiated and unirradiated areas.

Typically, the desired molar amounts of individual monomers of choice are dissolved in a compatible

solvent and introduced to one another in the presence of a polymerization initiator and a chain terminating agent. The reaction is conducted until the desired product is attained. Heating, cooling, stirring or degassing are conducted as the particular reaction kinetics require.

In addition to the polymers discussed above, the photosensitive composition will include a latent photoacid and a solvent and may optionally include stabilizers or other additives. The latent photoacid of the present invention will be chosen from substantially neutral substances capable of producing an acid after reaction with actinic radiation. The choice is determined by several factors, including the type of radiation to which sensitivity is desired. Clearly, the photoacid must absorb radiation at the frequency to be used, but it also must convert the radiation efficiently into the acid needed to crosslink the copolymers. In addition to being substantially non-acidic, the unexposed, latent photoacid must not react with the copolymer before exposure by actinic radiation and must be compatible with it. For example, the latent photoacid must not separate as a distinct macroscopic phase during preparation of the resist film. Also, the latent photoacid must not be so volatile that it tends to evaporate from the deposited film. Generally, the latent photoacids will have a boiling point of 150-200 °C or higher. It is desirable that the latent photoacid not be unstable at temperatures below about 90 °C, to allow for the possibility of a baking step, the purpose of which is to remove the resist solvent. Suitable compounds include the o-quinone-4-or-5-sulfonyl-diazides. It has been found that 4-sulfonyl isomer diazides generate more acid than other known diazide isomers, which renders this diazide class useful for this invention. Such sensitizing compounds are also disclosed, in United States Letters Patent Nos. 2,797,213; 3,106,465; 3,148,983; 3,130,047; 3,201,329; 3,785,825; and 3,802,885, which are incorporated herein by reference. The o-quinone diazides are well known to the skilled artisan as demonstrated by Light Sensitive Systems , Kosar, J.; John Wiley & Sons, New York, 1965 in Chapter 7.4 which is also incorporated herein by reference. It presently appears that the number of fused rings is not important for this invention but the position of the sulfonyl group is important.

That is, one may use benzoquinones, naphthoquinones or anthroquinones, preferably the oxygen is in the 1 position, diazo is in the 2 position and the sulfonyl group is in the 4 position. Likewise the phenolic member to which it is attached does not appear to be important. For example it can be a cumylphenol derivative as taught in U.S. 3,640,992 or it can be a mono-, di-, or tri-hydroxyphenyl alkyl ketone or benzophenone as shown in U.S. 4,499,171. Both of these patents are incorporated herein by reference.

Other compounds which liberate acids upon exposure non-exclusively include those taught in U.S. 4,101,323, incorporated herein by reference. Others are onium salts including sulfonium, diazonium and iodonium salts. Sulfonium salts are described in U.S. 4,537,854; diazonium salts are described in Kosar. Iodonium salts are described in U.S. Patent 4,603,101. Also included are trihalotriazines and compounds having the diazo-1,3 dione group are disclosed in U.S. 4,522,911; 4,339,522; 4,284,706; 4,622,283; 4,735,885 and 4,626,491 which are incorporated by reference. The preferred photoacids for the present invention produce strong acids such as $CF_3SO_3H$, p-toluene sulfonic acid, HCl and $H_2SO_4$.

The photosensitive composition is formed by blending the ingredients in a suitable solvent composition. In the preferred embodiment the resin is preferably present in the overall composition in an amount of from about 50% to about 99% based on the weight of the solid, i.e. non-solvent parts of the composition. A more preferred range of resin would be from about 80% to about 99% and most preferably from about 82% to about 95% by weight of the solid composition parts. The photoacid generator is preferably present in an amount ranging from about 1% to about 20% based on the weight of the solid, i.e., non-solvent parts of the composition. A more preferred range of the photoacid generator would be from about 1% to about 20% and more preferably from about 5% to about 20% by weight of the solid composition parts. In manufacturing the composition, the resin and sensitizer are mixed with such solvents as propylene glycol alkyl ether acetate, butyl acetate, ethylene glycol monoethyl ether acetate, diglyme, cyclopentanone and propylene glycol methyl ether acetate, among others.

Non-aromatic additives such as colorants, dyes, anti-striation agents, leveling agents, plasticizers, adhesion promoters, speed enhancers, solvents and such surfactants as non-ionic surfactants may be added to the solution of resin, sensitizer, and solvent before the solution is coated onto a substrate.

Anti-striation agents may be used up to five percent weight level, based on the combined weight of solids.

Optionally, the composition may contain other aqueous alkaline soluble resins such as one or more components selected from the group consisting of novolaks, poly(hydroxystyrene)homopolymers, and copolymers of hydroxystyrene and $C_1$ to $C_4$ alkyl substituted hydroxystyrene.

The coating solvents may be present in the overall composition in an amount of up to 95% by weight of the solids in the composition.

The prepared resist solution can be applied to a substrate by any conventional method used in the photoresist art, including dipping, spraying, whirling and spin coating. When spin coating, for example, the

resist solution can be adjusted as to the percentage of solids content in order to provide coating of the desired thickness given the type of spinning equipment utilized and the amount of time allowed for the spinning process. Suitable substrates include silicon, aluminum or polymeric resins, silicon dioxide, doped silicon dioxide, silicon nitride, tantalum, copper, polysilicon, gallium arsenide, ceramics and aluminum/copper mixtures.

In the production of the photographic element of the present invention, one coats and dries the foregoing photosensitive composition on a suitable substrate. The photoresist coatings produced are particularly suitable for application to thermally grown silicon/silicon dioxide-coated wafers such as are utilized in the production of microprocessors and other miniaturized integrated circuit components. An aluminum/aluminum oxide wafer can be used as well. The substrate may comprise silicon, aluminum, polymeric resins, silicon dioxide, doped silicon dioxide, silicon nitride, tantalum, gallium arsenide, Group III/V compounds, copper, polysilicon, ceramics and aluminum/copper mixtures as well as various polymeric resins especially transparent polymers such as polyesters. The substrate may have an adhesion promoted layer of a suitable composition such as hexa-alkyldisilazane.

After the resist composition solution is coated onto the substrate, the substrate is temperature treated at approximately 20° to 100° C. This temperature treatment is selected in order to reduce and control the concentration of residual solvents in the photoresist while not causing substantial thermal degradation of the photosensitizer. In general one desires to minimize the concentration of solvents and thus this temperature treatment is conducted until substantially all of the solvents have evaporated and a thin coating of photoresists composition, on the order of a micron in thickness, remains on the substrate. This treatment is normally conducted at temperatures in the range of from about 20° C to about 100° C. In a preferred embodiment the temperature is conducted at from about 50° C to about 90° C. A more preferred range is from about 70° C to about 90° C. This treatment is conducted until the rate of change of solvent removal becomes relatively insignificant. The temperature and time selection depends on the resist properties desired by the user as well as equipment used and commercially desired coating times. Commercially acceptable treatment times for hot plate treatment are those up to about 3 minutes, more preferably up to about 1 minute. In one example, a 30 second treatment at 90° is useful.

The coating substrate can then be exposed to actinic radiation, especially ultraviolet radiation, in any desired pattern, produced by use of suitable masks, negatives, stencils, templates, etc. in a manner well known to the skilled artisan. Exposure may be by electron beam or x-ray but the most preferred exposure is with ultraviolet radiation, especially deep ultraviolet radiation, i.e. at a wavelength of from about 220 -260 nm. Exposure causes the generation of an acid. The exposed coating is then subjected to a heating treatment wherein the acid catalyzes the crosslinking of the resin in the exposed areas. It is believed that the crosslinking takes place across the members $R_5$, $R_6$ and OX which contain oxygen. Heating is conducted for a sufficient time and at a sufficient temperature to effect crosslinking of the resin. The heating temperatures may range from about 70° C to about 150° C, more preferably from about 110° C to about 150° C. The heating may be conducted for from about 10 seconds to about 30 minutes, more preferably from about 45 seconds to about 90 seconds by hot plate or 10-30 minutes by oven. The development step may be conducted by immersion in a suitable developing solution. The solution is preferably agitated, for example, by nitrogen burst agitation. The substrates are allowed to remain in the developer until all, or substantially all, of the resist coating has dissolved from the unirradiated areas. Suitable developers include aqueous alkaline solutions such as those including sodium hydroxide, potassium hydroxide and tetramethyl ammonium hydroxide as are well known in the art.

The following specific examples will provide detailed illustrations of the methods of producing and utilizing compositions of the present invention. These examples are not intended, however, to limit or restrict the scope of the invention in any way and should not be construed as providing conditions, parameters or values which must be utilized exclusively in order to practice the present invention.

## Example 1

### N-methylol maleimide

Methylol maleimide is prepared similar to the method of Tawney, et al. [ J. Org. Chem. (1961) 26 , 15]. A two-liter flask is charged with 450 ml of 37% formalin solution, cooled externally to 16° C, and charged with 500 grams of recrystallized maleimide. While stirring strongly, 4.5 grams of 5% sodium hydroxide

solution is added dropwise. After an exothermic period, the product is warmed into solution at about 50° C. The solution is cooled gradually to 15° C and held at that temperature for one hour. The product is vacuum-filtered and dried. The yield is 575 grams (90% of theory), the melting point is 103.5-104° C. The product can be used without further purification. The remainder of the product may be recovered by drying the mother liquid of the reaction and recrystallizing the crude methylol maleimide from water or ethyl acetate. The melting point is 105 to 106.5° C. Conversion of maleimide to methylol maleimide is quantitative.

## Example 2

### Poly [N-(methylol) maleimide-co-styrene]

N-Methylol maleimide (25.4 grams) and styrene monomer (23.0 ml) are copolymerized in the presence of a chain terminating agent (2.0 ml dodecanethiol) and an initiator (222 mg azobisisobutyronitrile) in ethyl acetate (250 ml) at 60° C for 8 to 10 hours. On the following day, the reaction mixture is drowned into methanol (1 liter), filtered, washed with methanol, and dried under vacuum at 50° C. The yield is 40 grams (86% of theory).

Analytical:

Proton NMR: the spectrum is consistent with the composition.

DSC/TG: Onset 232° C and higher

TGA: The polymer loses 13% of its weight between 200 and 250° C. Methylol is theoretically 13.2% of the composition.

GPC: Typically Mw average = 23,000 - 27,000.

## Example 3

### Poly(styrene-co-N-methylol maleimide co-N-trimethyl siloxy methyl maleimide]

Poly(methylolmaleimide-co-styrene)(4.6 grams) is dissolved in 25 ml of tetrahydrofuran. The solution is cooled in an ice bath and 2.8 ml of trimethylsilyl chloride are dropped in. To the mixture is added 3.6 ml of pyridine. The mixture is warmed, diluted with 25 ml of THF and 50 ml of methanol. The entire mixture is drowned into 1 liter of deionized water, filtered, washed, and dried under high vacuum. The product weighs 5.9 grams (97% of theory).

Analytical: proton NMR indicates partial capping of the methylol group.

GPC: Average Mw 25,000

## Example 4

### Poly[N-(methylol) maleimide-co-maleimide-co-styrene]

Maleimide (14.6 grams), N-methylol maleimide (19.1 grams), and styrene monomer (17.2 ml) are copolymerized in the presence of a chain terminating agent (2.0 ml dodecanethiol) and an initiator (250 mg azobisisobutyronitrile) in ethyl acetate (250 ml) at 60° C for eight hours. On the following day, the reaction mixture is drowned into methanol (1 liter), filtered, washed with methanol, and dried under vacuum at 50° C. The yield is 35 grams (71% of theory).

## Example 5

Poly[N-(methylol) maleimide-co-maleic anhydride-co-styrene]

N-Methylolmaleimide (19.1 grams), maleic anhydride (14.7 grams), and styrene monomer (17.2 ml) are copolymerized in the presence of a chain terminating agent (2.0 ml dodecanethiol) and an initiator (250 mg azobisisobutyronitrile) in ethyl acetate (250 ml) at 60° C. After one hour, 50 ml of N-methylpyrrolidinone are added to dissolve the "gummy" product. At 4 1/2 hours the product is drowned into methanol and filtered. The product is redissolved in tetrahydrofuran and precipitated into 80% aqueous methanol (20% water, 80% methanol v:v). The product is filtered, washed with 80% aqueous methanol, and dried under vacuum at 50° C. The yield is 20.1 grams (41% of theory).

Example 6

Poly(3-methyl-4-Acetoxystyrene-co-N-Methylol Maleimide) (1:1) Copolymer

A 250 ml three necked jacketed flask is charged with 18.143 gm (0.103 moles) of 3-methyl-4-acetoxystyrene, 13.08 gm (0.103 moles) of N-methylol maleimide, 50 ml of dry ethyl acetate, 100 ml of diglyme and 0.6 gm of dodecanethiol. The flask is equipped with mechanical stirrer, nitrogen inlet tube and thermometer. The flask is degassed by purging with nitrogen. 0.105 gm of azobisisobutyronitrile is added to the flask. Hot water is circulated into the jacketed flask and maintained to ~ 60° C. The reaction solution becomes turbid and viscous. The reaction is maintained at 60° C for 10 hours. The reaction solution is then poured into 2.5 l of methanol, while stirring, by means of dropping funnel. A white precipitate forms. The precipitate is stirred additionally and then decanted before filtration. A white solid polymer settles at the bottom of the beaker. The polymer is filtered and washed several times with methanol and dried in a vacuum oven at 50° C for 3 nights. The yield of the polymer is 25 gm (80%). The copolymer has a glass transition temperature (Tg) of 240° C. TGA shows 2 phase decomposition in air. The first phase due to demethylolation, from 200-250° C (8% weight loss). The polymer decomposes at 650° C.

Example 7

The following photosensitive composition is prepared (all parts by weight):

| | |
|---|---|
| poly(styrene-co-N-methylol maleimide) - | 5.625 parts |
| diphenyl iodonium triflate - | 0.625 parts |
| diglyme (2-Methoxyethyl ether) - | 18.75 parts |

This composition is spin coated on a silicon wafer at a spin speed of 4,000 RPM. The coating is baked at 90° C for 30 minutes until dry to achieve a film thickness of about 2.5 micrometers (FTM). The coating is exposed to ultraviolet radiation at 260 nm at an energy level of 150 mJ/cm$^2$ using an Optoline(TM) exposure mask. The exposed coating is then given a post-exposure baking treatment at 110° C for 10 minutes. The coating is then developed in 0.15N AZ 312 MIF Developer commercially available from Hoechst Celanese Corporation, Somerville, New Jersey for 60 seconds. A negative tone relief image with fine resolution is obtained.

Sensitivity (@260nm)/2.5 micrometer film ~ 20 mJ/cm$^2$

Contrast (gamma) ~ 7.0

Dark Film Loss ~ 0.061 micrometer

Example 8

The following photosensitive composition is prepared:

| | |
|---|---|
| Poly[N-(methylol)maleimide-co-maleimide-co-styrene] | 2.25g |
| diphenyl iodonium triflate | 0.25g |
| diglyme (2-methoxyether ether) | 10.0 g |

The procedure of Example 7 is repeated, except the post exposure bake is conducted at 125° C for 10 minutes and the development is with 0.10N AZ 312 MIF Developer for 20 seconds. A sharp resolution relief image is obtained with no scum or striations. The coating is uniform with no adhesion failure even on unprimed wafers. The following results are noticed.

Photosensitivity: 10mJ/cm$^2$.

Contrast: ~5.0

Dark Film Loss: ~0.18 micrometer

Example 9

The procedure of Example 7 is repeated with the following changes:

| | |
|---|---|
| styrene-co-N-methylol maleimide-co-maleic anhydride - | 2.25gm |
| diphenyl iodonium triflate - | 0.25gm |
| diglyme - | 10.0gm |

Processing

4000 RPM to obtain a film thickness of 1.217 micrometer

Soft Bake : 90° C for 30 minutes

Exposure @ 260nm : 150 mJ/cm$^2$,

Post exposure bake : 110° C for 10 minutes

Developer : 0.27N AZ 312 MIF for 70 seconds

Results :

Photosensitivity: ~15 mJ/cm$^2$

Contrast : 8.3

Dark Film Loss : .002 micrometer

It is noted that the film is not very soluble in the base. Fibrous film peel-off from the developed regions are noted.

Example 10

The procedure of Example 7 is repeated with the following changes:

| | |
|---|---|
| 3-Methyl-4-Acetoxystyrene-co-N-Methylol Maleimide (1:1) - | 2.25gm |
| diphenyl iodonium triflate - | 0.25gm |
| diglyme - | 10.0gm |

Processing :

4000 RPM to obtain a film thickness of 0.95 micrometer

Soft Bake : 90° C for 30 minutes

Exposure : ~ 150 mJ/cm$^2$ @ 260 nm

Developer : 0.15N AZ 312 MIF for 60 seconds

Results :

Photosensitivity : ~ 15 mJ/cm$^2$

Contrast : ~ <2.0
Dark Film Loss : ~ 0.05 micrometer
Photosensitivity and contrast may be improved by changes in processing conditions.

Example 11

The procedure of example 7 is repeated with the following modifications:

| | |
|---|---|
| Poly(styrene-co-N-methylol maleimide co-N-trimethylsiloxy methyl maleimide) | 7.9g |
| diphenyl iodonium triflate | 0.567g |
| diglyme | 32.5g |

Spin Coated at 5000 RPM for 60 seconds to attain a 1,06 micrometer thickness
Soft baked at 90° C/20 minutes
Exposure at 260nm Broad Band
Post exposure baked at 130° C for 50 seconds on hot plate
Developed in 0.075N Tetramethylammonium hydroxide for 110 sec.
Photospeed = 37 mJ
Contrast = 7.7

**Claims**

1. A photosensitive composition which comprises
   a) an aqueous alkaline soluble, crosslinkable resin having the formula:

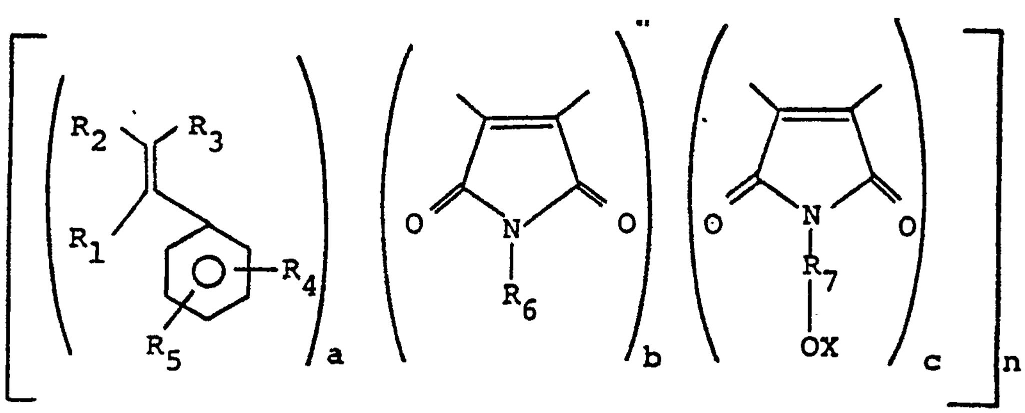

wherein $R_1$, $R_2$ and $R_3$ are independently $C_1$-$C_5$ alkyl or hydrogen;
$R_4$ is $C_1$-$C_5$ alkyl, halogen, hydrogen or $C_1$-$C_5$ alkyl substituted with halogen
$R_5$ is H, $C_1$ to $C_5$ alkyl, OCO($C_1$-$C_5$ alkyl), OH, halogen, ($C_1$-$C_5$) alkoxy or aryl
$R_6$ is ($C_1$-$C_5$ alkyl)OH, $C_1$-$C_5$ alkyl or hydrogen
$R_7$ is $C_1$-$C_5$ alkyl
X is H or

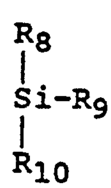

$R_8$, $R_9$ and $R_{10}$ are independently $C_1$-$C_5$ alkyl or phenyl
a = 1-3
b = 0-3
c = 1-3
n is a number to provide the resin a molecular weight in the range of from about 1,000 to about 800,000, wherein said resin is present in the composition in an amount sufficient to form a substantially uniform admixture of the composition components; and

b) at least one photosensitive compound capable of generating a sufficient amount of a strong acid upon exposure to radiant energy, such that said acid, upon subsequent heating for a sufficient time and at a sufficient temperature is capable of crosslinking the resin, to render the resin insoluble in an aqueous alkaline solution.

2. The composition of claim 1 wherein the resin is selected from poly(styrene-N-methylol maleimide), poly-(N-trimethylsiloxymethyl-maleimide-co-styrene)poly(N-methylol maleimide-co-3-methyl-4-acetoxystyrene), poly(styrene-co-maleic anhydride-co-N-methylol maleimide), poly(styrene-co-N-methylol maleimide-co-maleimide), poly(styrene-co-N-methylolmaleimide-co-N-trimethylsiloxymethyl maleimide), and poly-(chloromethylstyrene-co-N-methylol maleimide).

3. The composition of claim 1 or 2 which further comprises one or more resins selected from novolak resins, polyvinyl phenols and polystyrene maleimide.

4. The composition of any of claims 1-3 wherein the photosensitive compound is selected from orthoquinone diazides, naphthoquinone diazides, trihalomethyl triazines, and onium salts.

5. The composition of claim 4 wherein the photosensitive compound is selected from diphenyl iodonium triflate; the condensation product of a hydroxybenzophenone with a 1,2 naphthoquinone-2-diazide-4-sulfonyl chloride; and the condensation product of a 2,3,4-trihydroxybenzophenone with a 90/10 weight ratio mixture of 1,2-naphthoquinone-2-diazide-4-sulfonyl chloride and 1,2-naphthoquinone-2-diazide-5-sulfonyl chloride.

6. The composition of any of claims 1-5 further comprising one or more solvents selected from propylene glycol alkyl ether acetate, butyl acetate, ethylene glycol monoethyl ether acetate, diglyme, cyclopentanone and propylene glycol methyl ether acetate.

7. The composition of any of claims 1-6 further comprising one or more components selected from non-aromatic colorants, dyes, anti-striation agents, leveling agents, plasticizers, adhesion promoters, speed enhancers, solvents and surfactants.

8. A photosensitive element which comprises a substrate and a layer of the composition of any of claims 1-7 coated on said substrate.

9. The element of claim 8 wherein the substrate is selected from silicon, aluminum, polymeric resins, silicon dioxide, doped silicon dioxide, gallium arsenide, Group III/V compounds, silicon nitride, tantalum, copper, polysilicon, ceramics and aluminum/copper mixtures.

10. A method of producing a negative image which comprises,

i) imagewise exposing the layer of the photosensitive composition of the element of claim 8 or 9 to sufficient radiant energy to generate an acid from the photosensitive compound;

ii) heating said exposed layer for a sufficient time and at a sufficient temperature to crosslink the resin in the imagewise exposed portions of the layer while substantially not crosslinking said resin in the imagewise non-exposed portions of the layer; and

iii) removing the imagewise non-exposed portions with an aqueous alkaline developer.

11. The method of claim 10 wherein the exposure step is conducted with actinic, x-ray or ion beam radiation.

12. The method of claim 10 wherein the exposure step is conducted with ultraviolet radiation having a wavelength of from 220nm to 260nm.

13. The method of any of claims 10-12 wherein the developing step is conducted with sodium hydroxide, potassium hydroxide or tetramethyl ammonium hydroxide.

14. The method of any of claims 10-13 wherein the heating step is conducted for from 10 seconds to 30 minutes at a temperature of from 70°C to 150°C.

15. A resin having the formula:

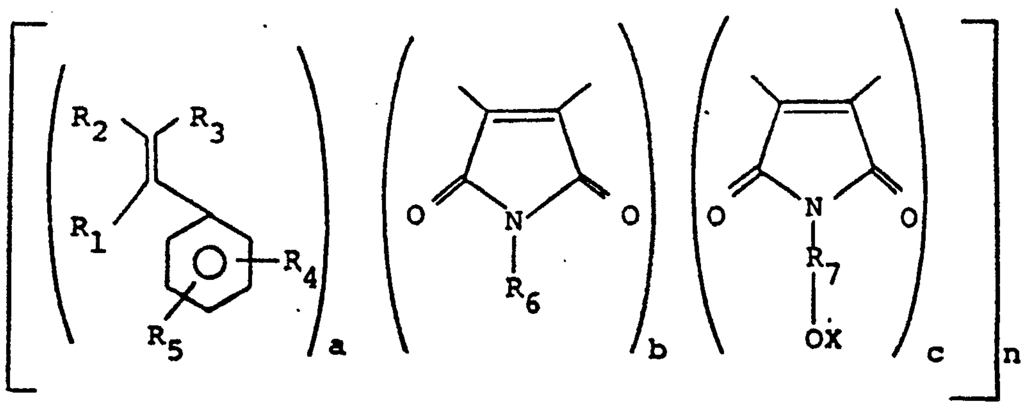

wherein $R_1$, $R_2$, and $R_3$ are independently $C_1$-$C_5$ alkyl or hydrogen;
$R_4$ is $C_1$-$C_5$ alkyl, halogen, hydrogen or $C_1$-$C_5$ alkyl substituted with halogen
$R_5$ is H, $C_1$ to $C_5$ alkyl, OCO($C_1$-$C_5$ alkyl), OH, halogen, ($C_1$-$C_5$) alkoxy or aryl
$R_6$ is ($C_1$-$C_5$ alkyl) OH, $C_1$-$C_5$ alkyl or hydrogen
$R_7$ is $C_1$-$C_5$ alkyl
X is H or

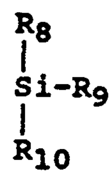

$R_8$, $R_9$ and $R_{10}$ are independently $C_1$-$C_5$ alkyl or phenyl
a = 1-3
b = 0-3
c = 1-3
n is a number to provide the resin a molecular weight in the range of from about 1,000 to about 800,000.

16. The resin of claim 15 wherein c is 1-3 and X is